# EUROPEAN PATENT APPLICATION

(11) **EP 4 525 237 A1**
(43) Date of publication of application: **19.03.2025**
(21) Application number: 24197225.6
(22) Date of filing: 29.08.2024
(51) Int. Cl.: H02H 3/093

(54) **LOAD SWITCH SYSTEM WITH MIS-WIRING DETECTION AND PROTECTION**

(30) Priority: 04.09.2023 US 202363536484 P; 05.08.2024 US 202418794428
(71) Applicant: Analog Devices International Unlimited Company, Co. Limerick (IE)
(72) Inventor: Ranieri, Danilo, Limerick (IE); Wagner, Reinhardt, Limerick (IE)
(74) Representative: Horler, Philip John

(57) **Abstract**

A load switch system and method of manufacture can include: configuring a power switch to complete or interrupt a power circuit; coupling a low current comparator for comparing the current to a low current threshold and outputting a first current threshold signal; coupling a filter to the low current comparator, the filter outputs the first current threshold signal after a predefined length of time; coupling a high current comparator to the current sensor, the high current comparator compares the current to a high current threshold and outputs a second current threshold signal; and coupling a control logic to the low current comparator and to the high current comparator, the control logic opens the power switch and interrupts the power circuit based on the second current threshold signal being output by the high current comparator or the first current threshold signal being output by the filter.

## Description

### TECHNICAL FIELD

This disclosure relates to industrial load switches, more particularly to the detection and protection of mis-wiring in high side and low side load switches.

### BACKGROUND

Load switches are used in industrial environments to control the supply of power to loads. Load switches can be transistor based but can also employ any type of switch including discrete relays. Further, load switches can be of two types including high side and low side. Low side load switches operate by completing or interrupting a ground connection in a power circuit between a power supply and the load while high side load switches operate by completing or interrupting a supply connection in a power circuit between the power supply and the load.

Load switches are able to drive multiple loads with large current and a relatively high data rate in the hundreds of kilohertz range, where the loads are turned on and off quickly. The loads can be any type of load but are commonly factory hardware and tooling, for example, including actuators, motors, drivers, integrated circuit boards, and the like.

One issue arising with load switches is mis-wiring between the load switch and one of the many loads due to human error. Mis-wiring can arise during installation, maintenance, and upgrade procedures.

Mis-wiring can cause extended down time, increased troubleshooting and repair costs, and can even result in damage or complete destruction of the loads, the load switch, and to power supplies used to power the loads. To avoid damage from mis-wiring, prior developments implemented current limit triggers that would de-activate switches within the load switch.

These prior developments, although solving one problem, introduced other problems including false triggering of the current limit triggers. False triggering can result when long connection wires are used between the load switch and the load, which can allow for a large alternating current, or ringing, superimposed onto a direct current supplied to the load.

If large enough, the alternating current can appear to the current limit trigger to be a mis-wiring and the current limit trigger will respond by shutting down the switches within the load switch to all loads connected thereto and simultaneously open a reverse protection switch to an external ground or supply voltage. This can occur even when the loads are properly connected to the load switch and can result in the difficult problem of intermittent improper functioning of the load.

In some cases, the load switch will execute a number of auto-retries attempting to re-power the load after a time delay. During this auto-retry period, the load switch is off and blind.

Under these conditions the load could fail to operate, and some powered loads could lose power during operation requiring a full or even manual reset leading to unacceptable tool down time or unacceptable troubleshooting and repair costs. As a consequence, prior developments can fail intermittently and dramatically when in normal operation by generating false detections, and so lose functionality when implemented with long wires and capacitive loads which is commonplace in industrial applications.

Solutions have been long sought but prior developments have not taught or suggested any complete solutions, and solutions to these problems have long eluded those skilled in the art. Thus, there remains a considerable need for devices and methods that can provide reliable mis-wiring detection and protection for a load switch in an industrial environment.

### BRIEF DESCRIPTION OF THE DRAWINGS

The load switch system is illustrated in the figures of the accompanying drawings which are meant to be exemplary and not limiting, in which like reference numerals are intended to refer to like components, and in which:
FIG. 1 is a block diagram of the load switch system in a low side switch embodiment.
FIG. 2 is a block diagram of the load switch system of FIG. 1 in a weak current mis-wiring.
FIG. 3 is a block diagram of the load switch system of FIG. 1 in a strong current mis-wiring.
FIG. 4 is a timing diagram of the load switch system of FIG. 1 with a small LC.
FIG. 5 is a timing diagram of the load switch system of FIG. 1 with a large LC.
FIG. 6 is a schematic diagram of the switch module of FIG. 1 with N-type low side switches.
FIG. 7 is a schematic diagram of the switch module of FIG. 1 with generic switches.
FIG. 8 is a block diagram of the load switch system in a high side switch embodiment.
FIG. 9 is a schematic diagram of the switch module of FIG. 8 with N-type high side switches.
FIG. 10 is a schematic diagram of the switch module of FIG. 8 with P-type high side switches.
FIG. 11 is a block diagram of a method of manufacturing the load switch system.

### DETAILED DESCRIPTION

In the following description, reference is made to the accompanying drawings that form a part hereof, and in which are shown by way of illustration, embodiments in which the load switch system may be practiced. It is to be understood that other embodiments may be utilized and structural changes may be made without departing from the scope of the load switch system.

When features, aspects, or embodiments of the load switch system are described in terms of steps of a process, an operation, a control flow, or a flow chart, it is to be understood that the steps can be combined, performed in a different order, deleted, or include additional steps without departing from the load switch system as described herein.

The load switch system is described in sufficient detail to enable those skilled in the art to make and use the load switch system and provide numerous specific details to give a thorough understanding of the load switch system; however, it will be apparent that the load switch system may be practiced without these specific details.

In order to avoid obscuring the load switch system, some well-known system configurations and descriptions are not disclosed in detail. Likewise, the drawings showing embodiments of the system are semi-diagrammatic and not to scale and, particularly, some of the dimensions are for the clarity of presentation and are shown greatly exaggerated in the drawing FIGs. As used herein, the term "couple" as in "coupled" or "coupling" is defined as a direct or indirect physical connection between coupled elements.

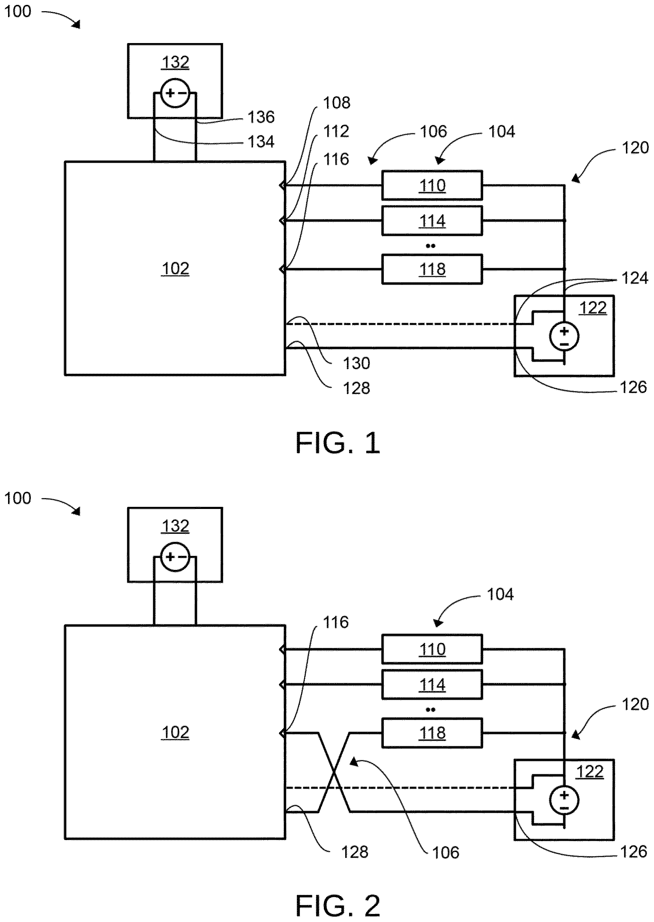

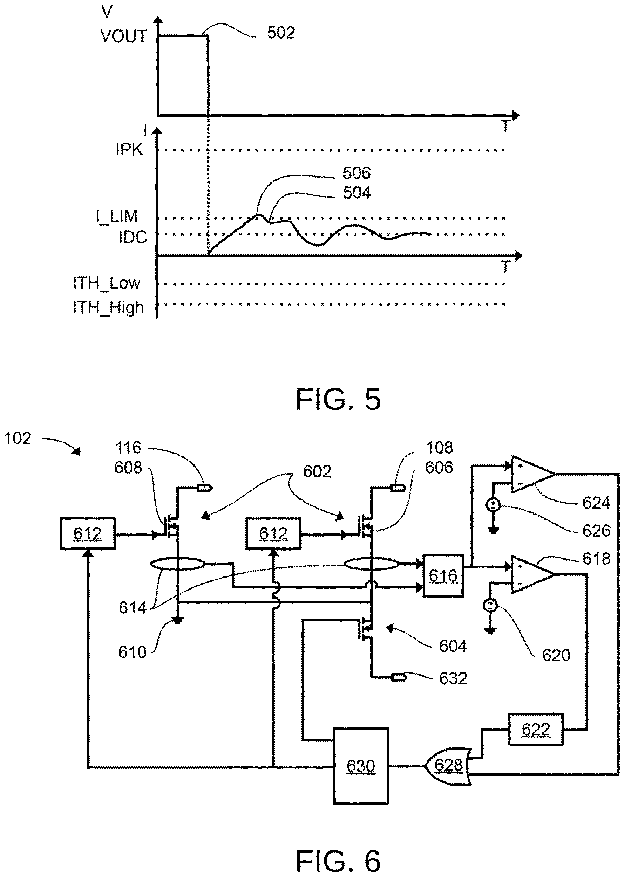

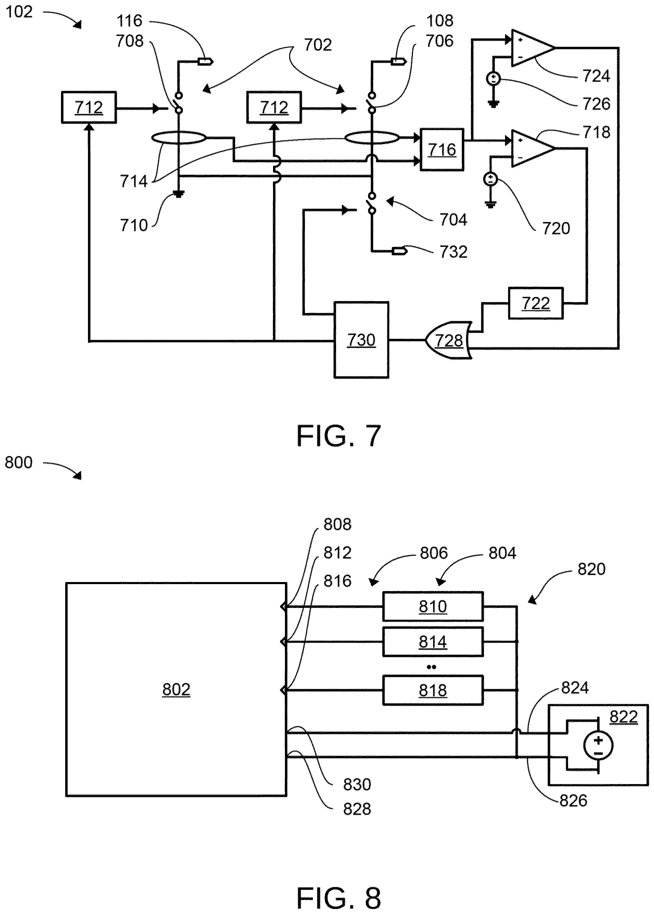

Referring now to FIG. 1, therein is shown a block diagram of the load switch system 100 in a low side switch embodiment. The load switch system 100 can include a switch module 102 containing at least one power switch as shown and described below with regard to FIGs. 6 and 7.

The switch module 102 can be coupled to multiple loads 104 with connection lines 106. More particularly the switch module 102 is shown having a first output 108 coupled to a first load 110, a second output 112 coupled to a second load 114, and an nth output 116 coupled to an nth load 118.

In an industrial setting the connection lines 106 can be long, including lengths measured in kilometers. The switch module 102 can complete or interrupt a power circuit 120 between a power supply 122 and one or more of the loads 104.

The power supply 122 can include a power supply positive terminal 124 and a power supply negative terminal 126. The power circuit 120 can consist of one of the loads 104 coupled to power supply positive terminal 124 and the power supply negative terminal 126 with the connection lines 106.

The load switch system 100 in the low side switch embodiment will have the power supply negative terminal 126 selectively connected to the load 104 through power switches in the switch module 102 while the loads 104 are directly connected to the power supply positive terminal 124. The power circuit 120 can be completed for each of the loads 104 individually allowing current to flow through a load and thereby power the load.

When interrupted by one of the power switches within the switch module 102, current within the power circuit 120 is shut off by removing a connection to ground and de-powering the load 104. The switch module 102 can include a switching module ground terminal 128 which, in normal operation, is connected to the power supply negative terminal 126.

The switch module 102 can optionally have a switch module positive terminal 130 coupled to the power supply positive terminal 124 and thereby provide power to the switch module 102. The switch module positive terminal 130 is depicted with a broken line to indicate that the positive power connection 130 between the switch module 102 and the power supply 122 is optional. When used, the positive power connection 130 can provide operating power to the switch module 102.

In cases or designs where a connection between the switch module positive terminal 130 and the power supply positive terminal 124 is not made, the switch module 102 can be coupled to a secondary power supply 132, which could be located on a backplane. When the secondary power supply 132 is used, the secondary power supply 132 can provide power to the switch module 102 and provide power to activate the power switches within the switch module 102.

The secondary power supply 132 can provide both a secondary power supply positive terminal 134 and a secondary power supply negative terminal 136 to the switch module 102. The secondary power supply 132 can be galvanically isolated or non-isolated from the power supply 122.

Referring now to FIG. 2, therein is shown a block diagram of the load switch system 100 of FIG. 1 in a weak current mis-wiring. In this illustrative mis-wiring configuration, the switch module 102 is shown with the nth output 116 coupled to the power supply negative terminal 126 with one of the connection lines 106.

Furthermore, the switching module ground terminal 128 is connected to the nth load 118 with another connection line 106. This mis-wiring configuration will turn the nth load 118 on continuously.

The current through the power circuit 120 will be the voltage of the power supply 122 divided by the resistance of the nth load 118. This is considered a weak current as the loads 104 can be designed to handle this current for a short amount of time before being destroyed by the current.

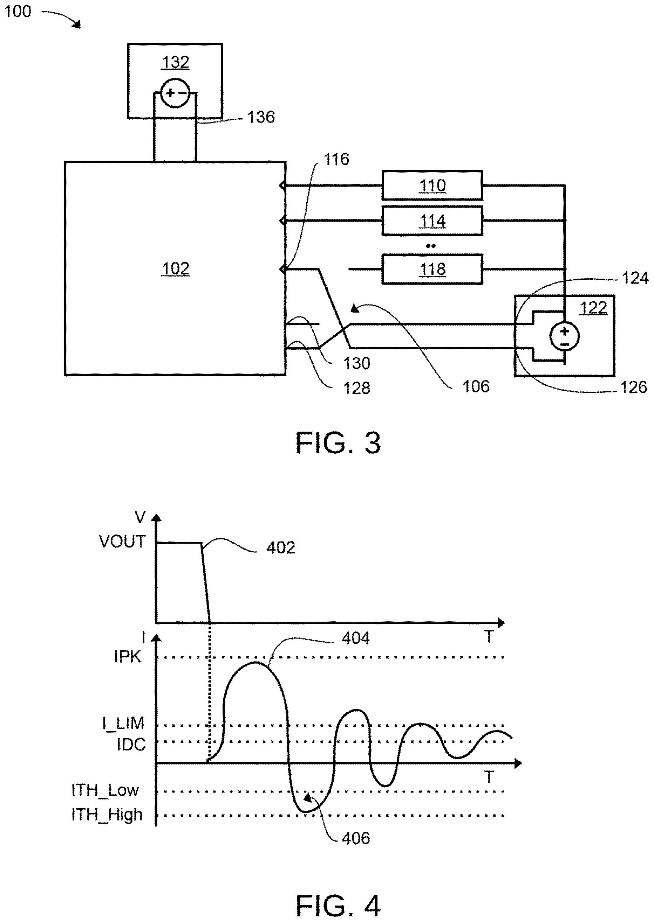

Referring now to FIG. 3, therein is shown a block diagram of the load switch system 100 of FIG. 1 in a strong current mis-wiring. In this illustrative mis-wiring configuration, the switch module 102 is shown without the optional switch module positive terminal 130 coupled to the power supply positive terminal 124 and is instead utilizing the secondary power supply 132 for power within the switch module 102.

Furthermore, the switch module 102 is shown with the nth output 116 coupled to the power supply negative terminal 126 with one of the connection lines 106 and the nth load 118 left open, not connected to the switch module 102. The power supply positive terminal 124 is shown connected to the switching module ground terminal 128 with another one of the connection lines 106.

This mis-wiring configuration will send a strong current from the power supply 122 through the secondary power supply negative terminal 136 limited only by the current capability of the power supply 122. This large current can destroy components within the secondary power supply 132 and the switch module 102.

That is, the strong current mis-wiring can be as large as 10 or 20 amps. This requires a very short microsecond detection time to turn off all power switches within the switch module 102.

Referring now to FIG. 4, therein is shown a timing diagram of the load switch system 100 of FIG. 1 with a small LC, measured in units of seconds squared. The "L" component of the LC attribute can be due to long connection lines 106 of FIG. 1 and the "C" component of the LC attribute can be due to capacitance of the remote load 104 of FIG. 4.

The load switch system 100 can complete the power circuit 120 of FIG. 1 through one of the loads by initiating a DC voltage 402 on one of the power switches within the switch module 102 of FIG. 1. The DC voltage 402 is represented within the top timing diagram with voltage measured in volts indicated along the vertical axis and time measured in microseconds indicated along the horizontal axis.

The DC voltage 402 can initiate current 404 through the power circuit 120. The current 404 is represented within the bottom timing diagram with current (I) in amps indicated along the vertical axis and time measured in microseconds indicated along the horizontal axis, and with the horizontal axis representing zero amps.

As can be seen the current 404 can be a forward current (I) above the horizontal axis and a reverse current (ITH) below the horizontal axis. IDC represents the DC current the loads 104 are designed to receive when the power circuit 120 is completed.

ITH_low represents a low reverse current detection threshold for a low side switch or a high side switch. The low reverse current detection threshold ITH_low can be exceeded when the current 404 is a larger reverse current than indicated by the low reverse current detection threshold.

ITH_high represents a high reverse current detection threshold for a low side switch or a high side switch. The high reverse current detection threshold ITH_high can be exceeded when the current 404 is a larger reverse current than indicated by the high reverse current detection threshold.

I_LIM represents a current limit level for the switch in the case of a permanent high current condition. IPK represents a peak current due to the small LC ringing. IPK is not controlled by the load switch system 100 and is not a parameter set by the switch module 102.

The current 404 is shown oscillating between forward and reverse current, which is known as ringing. Ringing can come from the inductance of the connection lines 106, which can be Kilometers long while the capacitance can come from the loads 104, which can have large capacitances of milli farads. This ringing can produce reverse current detection events 406.

If the reverse current detection events 406 occur, the switch module 102 will turn off all power switches within the switch module 102. This switch turn-off event can last for seconds in some cases and some switch modules 102 will initiate a reset sequence, which can sometimes be repeated over multiple cycles, and taking the switch module 102 offline for even longer.

When the reverse current detection events 406 occur due to ringing, the switch module 102 should not handle the reverse current detection events 406 this way as it interferes with the normal operation of the system. Instead, the connection lines 106 and the loads 104 should be given a settling time for the ringing current to stabilize, or "settle", to the desired IDC current.

For example, the settling time could be the average time it takes for the current to oscillate between the I_PK and the ITH_Low. It is also contemplated that the settling time could be the maximum time it takes for the current to oscillate within a pre-determined percentage of IDC. Yet further it is contemplated that the settling time could be the maximum time it takes for the current to oscillate above the ITH_Low.

No immediate interruption of the power circuit 120 should be initiated because the loads 104 are designed to handle the currents involved in ringing. The high reverse current detection thresholds (ITH_high) should be greater than the peak currents induced by ringing.

Referring now to FIG. 5, therein is shown a timing diagram of the load switch system 100 of FIG. 1 with a large LC. The "L" component of the large LC attribute can be due to long connection lines 106 of FIG. 1 and the "C" component of the large LC attribute can be due to the remote load 104.

The load switch system 100 can complete the power circuit 120 of FIG. 1 through one of the loads 104 by initiating a DC voltage 502 on one of the power switches within the switch module 102 of FIG. 1. The DC voltage 502 is represented within the top timing diagram with voltage measured in volts indicated along the vertical axis and time measured in microseconds indicated along the horizontal axis.

The DC voltage 502 can initiate current 504 through the power circuit 120. The current 504 is represented within the bottom timing diagram with current in amps indicated along the vertical axis and time measured in microseconds indicated along the horizontal axis, and with the horizontal axis representing zero amps.

The current 504 is described as a forward current (I) above the horizontal axis and a reverse current (ITH) below the horizontal axis. IDC represents the DC current the loads 104 are designed to receive when the power circuit 120 is completed. The current 504 is shown oscillating about the IDC with the current 404 slowly rising to overshoot I_LIM and cause a current limiting event 506.

Referring now to FIG. 6, therein is shown a schematic diagram of the switch module 102 of FIG. 1 with N-type low side switches. The switches can be any type of switch including field effect transistors, bipolar transistors, or relays. The N-type low side switches are depicted as power switches 602 and a protection switch 604.

The power switches 602 are shown as the first power switch 606 and an nth power switch 608. The first power switch 606 can provide the first output 108 of the switch module 102.

When activated, the first power switch 606 can connect the first output 108 to an internal ground 610. The internal ground 610 is internal to the switch module 102 and can be provided by the secondary power supply 132 of FIG. 1 or the power supply 122 of FIG. 1.

Similarly, the nth power switch 608 can provide the nth output 116 and can connect the nth output 116 to the internal ground 610 when activated. For descriptive clarity, power switches 602 for other outputs of the switch module 102, such as the second output 112 of FIG. 1 is not shown but has the same structure and operation as those depicted.

The power switches 602 are individually configured to complete the power circuit 120 of FIG. 1 between the power supply 122 and one of the loads 104 when activated and are configured to interrupt the power circuit 120 when deactivated. The power switches 602 can be activated and deactivated with switch drivers 612, which can provide the drive signal for activating and deactivating the power switches 602.

The switch drivers 612 can provide the low activation voltage, such as the DC voltage 502 of FIG. 5 or the DC voltage 402 of FIG. 4, for activating the power switches 602. The switch drivers 612 and the power switches 602 can be powered by the secondary power supply 132.

Between the internal ground 610 and the power switches 602, a current can be detected. The current can be the current 504 of FIG. 5 or the current 404 of FIG. 4, which is the current within the power circuit 120. The current from each of the power switches 602 can be detected by an individual current sensor 614.

The individual current sensors 614 are positioned between each of the power switches 602 and the protection switch 604. The output of the current sensors 614 can be input into a current to voltage converter 616. The current to voltage converter 616 can be an operational amplifier based component which can output a voltage linearly related to the input current.

The output of the current to voltage converter 616 can be input into a low current comparator 618. The low current comparator 618 compares the current to a low current threshold 620, such as the low reverse current detection threshold ITH_low of FIG. 4, and outputs a first current threshold signal based on the low current threshold 620 being exceeded by the current.

The output of the low current comparator 618 either indicates the first current threshold signal or a non-first current threshold signal. The non-first current threshold signal being a signal based on the low current threshold 620 not being exceeded by the current. The output of the low current comparator 618 is input into a debounce filter 622.

The debounce filter 622 can output a change in state from the non-first current threshold signal to the first current threshold signal if the low current threshold 620 is exceeded by the current for a predefined length of time. The predefined length of time can be the duration of the current settling time for the ringing current through the power circuit 120. Illustratively, for example, it has been discovered that using the current settling time of the ringing current as the predefined length time for the debounce filter 622 affords an unexpected solution to ringing current through the power circuit 120 because the current is allowed to ring for a length of time long enough to correct itself without keeping the power circuit 120 active when there is a weak mis-wiring, such as that depicted in FIG. 2.

This implementation of the debounce filter 622 therefore prevents the power circuit 120 from being interrupted during normal operation. The predefined length of time for the debounce filter 622 can vary based on the frequency of the ringing.

The output of the current to voltage converter 616 can also and additionally be input into a high current comparator 624. The high current comparator 624 compares the current to a high current threshold 626, such as the high reverse current detection threshold ITH_high of FIG. 4, and outputs a second current threshold signal based on the high current threshold 626 being exceeded by the current.

The output of the high current comparator 624 either indicates the second current threshold signal or a non-second current threshold signal. The non-second current threshold signal being a signal based on the high current threshold 626 not being exceeded by the current. The high current comparator 624 is not shown coupled to a debounce filter because the second current threshold signal output of the high current comparator 624 can be an indication of a strong current mis-wiring such as that depicted in FIG. 3.

Because the second current threshold signal can indicate the strong current mis-wiring, it should be handled quickly, which makes a debounce filter an impractical solution in most cases. The output of the high current comparator 624 and the debounce filter 622 can be input into an OR logic gate 628, which can output a digital signal indicating either the second current threshold signal is present from the high current comparator 624, the first current threshold signal is present from the debounce filter 622, or both signals are present.

If the second current threshold signal is not present and the first current threshold signal is not present, then the OR logic gate 628 will indicate that neither the low current threshold 620 nor the high current threshold 626 were exceeded by the current.

While the low current comparator 618 and the high current comparator 624 are depicted as operational amplifier based, any circuit providing the comparison function is contemplated. The low current comparator 618 and the high current comparator 624 can be coupled to a control logic 630. The control logic 630 can be coupled to the high current comparator 624 through the OR logic gate 628 while the control logic 630 can be coupled to the low current comparator 618 through the OR logic gate 628 and the debounce filter 622.

The control logic 630 opens each of the power switches 602 and interrupts the power circuit 120 based on the second current threshold signal being output by the high current comparator 624 or the first current threshold signal being output by the debounce filter 622. More particularly, the control logic 630 can provide a signal to the switch drivers 612 which will open the power switches 602.

The control logic 630 can also provide a signal to the protection switch 604 in order to connect the internal ground 610 and the power switches 602 to an external ground 632, which can be a true earth ground. The protection switch 604 can be coupled to the power switches 602 and to the control logic 630.

The protection switch 604 exposes the power circuit 120 to an external connection based on the second current threshold signal being output by the high current comparator 624 or the first current threshold signal being output by the debounce filter 622. The external connection can be an external ground for low side switches and an external voltage for high side switches.

Referring now to FIG. 7, therein is shown a schematic diagram of the switch module 102 of FIG. 1 with generic switches. The generic switches can be relays and are depicted as power switches 702 and a protection switch 704.

The power switches 702 are shown as a first power switch 706 and an nth power switch 708. The first power switch 706 can provide the first output 108 of the switch module 102.

When activated, the first power switch 706 can connect the first output 108 to an internal ground 710. The internal ground 710 is internal to the switch module 102 and can be provided by the secondary power supply 132 of FIG. 1 or the power supply 122 of FIG. 1.

Similarly, the nth power switch 708 can provide the nth output 116 and can connect the nth output 116 to the internal ground 710 when activated. For descriptive clarity, power switches 702 for other outputs of the switch module 102, such as the second output 112 of FIG. 1 is not shown but has the same structure and operation as those depicted.

The power switches 702 are individually configured to complete the power circuit 120 of FIG. 1 between the power supply 122 and one of the loads 104 when activated and are configured to interrupt the power circuit 120 when deactivated. The power switches 702 can be activated and deactivated with switch drivers 712, which can provide the drive signal for activating and deactivating the power switches 702.

The switch drivers 712 can provide the low activation voltage, such as the DC voltage 502 of FIG. 5 or the DC voltage 402 of FIG. 4, for activating the power switches 702. The switch drivers 712 and the power switches 702 can be powered by the secondary power supply 132.

Between the internal ground 710 and the power switches 702, a current can be detected. The current can be the current 504 of FIG. 5 or the current 404 of FIG. 4, which is the current within the power circuit 120. The current from each of the power switches 702 can be detected by an individual current sensor 714.

The individual current sensors 714 can be positioned between each of the power switches 702 and the protection switch 704. The output of the current sensors 714 can be input into a current to voltage converter 716. The current to voltage converter 716 can be an operational amplifier based component which can output a voltage linearly related to the input current.

The output of the current to voltage converter 716 can be input into a low current comparator 718. The low current comparator 718 compares the current to a low current threshold 720, such as the low reverse current detection threshold ITH_low of FIG. 4, and outputs a first current threshold signal based on the low current threshold 720 being exceeded by the current.

The output of the low current comparator 718 either indicates the first current threshold signal or a non-first current threshold signal. The non-first current threshold signal being a signal based on the low current threshold 720 not being exceeded by the current. The output of the low current comparator 718 is input into a debounce filter 722.

The debounce filter 722 can output a change in state from the non-first current threshold signal to the first current threshold signal if the low current threshold 720 is exceeded by the current for a predefined length of time. Illustratively, for example, it has been discovered that using the current settling time of the ringing current as the predefined length time for the debounce filter 722 affords an unexpected solution to ringing current through the power circuit 120 because the current is allowed to ring for a length of time long enough to correct itself without keeping the power circuit 120 active when there is a weak mis-wiring, such as that depicted in FIG. 2.

This implementation of the debounce filter 722 therefore prevents the power circuit 120 from being interrupted during normal operation. The predefined length of time for the debounce filter 722 can vary based on the frequency of the ringing.

The output of the current to voltage converter 716 can also and additionally be input into a high current comparator 724. The high current comparator 724 compares the current to a high current threshold 726, such as the high reverse current detection threshold ITH_high of FIG. 4, and outputs a second current threshold signal based on the high current threshold 726 being exceeded by the current.

The output of the high current comparator 724 either indicates a second current threshold signal or a non-second current threshold signal. The non-second current threshold signal being a signal based on the high current threshold 726 not being exceeded by the current. The high current comparator 724 is not shown coupled to a debounce filter because the second current threshold signal output from the high current comparator 724, can be an indication of a strong current mis-wiring such as that depicted in FIG. 3.

Because the second current threshold signal can indicate the strong current mis-wiring, it should be quickly, which makes a debounce filter an impractical solution in most cases. The output of the high current comparator 724 and the debounce filter 722 can be input into an OR logic gate 728, which can output a digital signal indicating either the second current threshold signal is present from the high current comparator 724, the first current threshold signal is present from the debounce filter 722, or both signals are present.

If the second current threshold signal is not present and the first current threshold signal is not present, then the OR logic gate 728 will indicate that neither the low current threshold 720 nor the high current threshold 726 were exceeded by the current.

The low current comparator 718 and the high current comparator 724 can be coupled to a control logic 730. The control logic 730 can be coupled to the high current comparator 724 through the OR logic gate 728 while the control logic 730 can be coupled to the low current comparator 718 through the OR logic gate 728 and the debounce filter 722.

The control logic 730 opens each of the power switches 702 and interrupts the power circuit 120 based on the second current threshold signal being output by the high current comparator 724 or the first current threshold signal being output by the debounce filter 722. More particularly, the control logic 730 can provide a signal to the switch drivers 712 which will open the power switches 702.

The control logic 730 can also provide a signal to the protection switch 704 in order to connect the internal ground 710 and the power switches 702 to an external ground 732, which can be a true earth ground. The protection switch 704 can be coupled to the power switches 702 and to the control logic 730.

The protection switch 704 exposes the power circuit 120 to an external connection based on the second current threshold signal being output by the high current comparator 724 or the first current threshold signal being output by the debounce filter 722. The external connection can be an external ground for low side switches or an external voltage for high side switches.

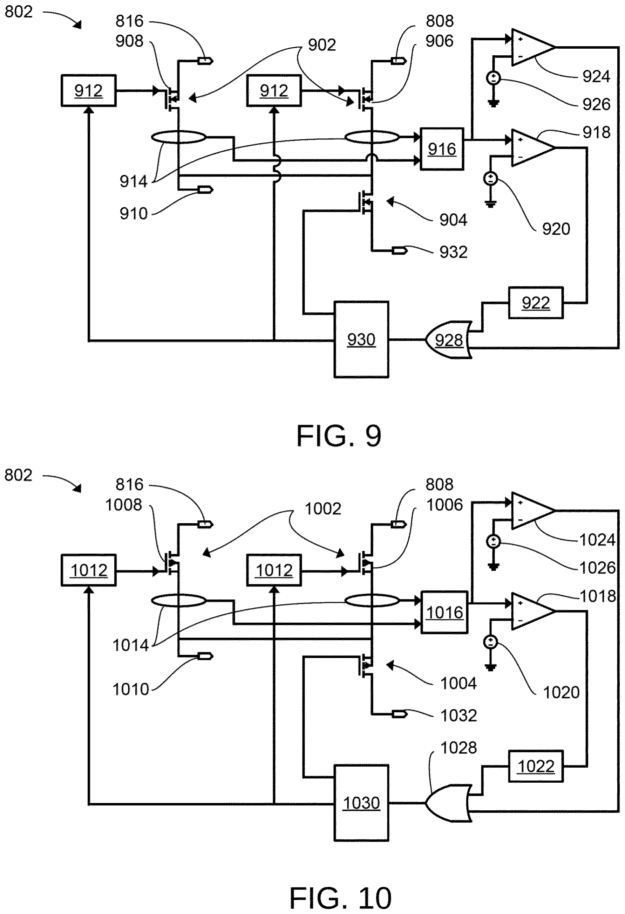

Referring now to FIG. 8, therein is shown a block diagram of the load switch system 800 in a high side switch embodiment. The load switch system 800 can include a switch module 802 containing at least one power switch as shown and described below with regard to FIGs. 9, and 10.

The switch module 802 can be coupled to multiple loads 804 with connection lines 806. More particularly the switch module 802 is shown having a first output 808 coupled to a first load 810, a second output 812 coupled to a second load 814, and an nth output 816 coupled to an nth load 818.

In an industrial setting the connection lines 806 can be long, including lengths measured in kilometers. The switch module 802 can complete or interrupt a power circuit 820 between a power supply 822 and one or more of the loads 804.

The power supply 822 can include a power supply positive terminal 824 and a power supply negative terminal 826. The power circuit 820 can consist of one of the loads 804 coupled to power supply positive terminal 824 and the power supply negative terminal 826 with the connection lines 806.

The load switch system 800 in the high side switch embodiment selectively connects the load 804 to the power supply positive terminal 824 through power switches in the switch module 802 while the loads 804 can be directly connected to the negative terminal 826. The power circuit 820 can be completed for each of the loads 804 individually allowing current to flow through a load and thereby power the load.

When interrupted by one of the power switches within the switch module 802, current within the power circuit 820 is shut off by removing a connection to the power supply positive terminal 824 and de-powering the load 804. The switch module 802 can include a switching module ground terminal 828 which, in normal operation, is connected to the power supply negative terminal 826. The switch module 802 is also shown having a switch module positive terminal 830 coupled to the power supply positive terminal 824 and thereby provide power to the switch module 802.

Referring now to FIG. 9, therein is shown a schematic diagram of the switch module 802 of FIG. 8 with N-type high side switches. The N-type high side switches are depicted as power switches 902 and a protection switch 904.

The power switches 902 are shown as a first power switch 906 and an nth power switch 908. The first power switch 906 can provide the first output 808 of the switch module 802.

When activated, the first power switch 906 can connect the first output 808 to an internal voltage 910. The internal voltage 910 is internal to the switch module 802 and can be provided by connection to the power supply positive terminal 824 of FIG. 8.

Similarly, the nth power switch 908 can provide the nth output 816 and can connect the nth output 816 to the internal voltage 910 when activated. For descriptive clarity, power switches 902 for other outputs of the switch module 802, such as the second output 812 of FIG. 8 is not shown but has the same structure and operation as those depicted.

The power switches 902 are individually configured to complete the power circuit 820 of FIG. 8 between the power supply 822 of FIG. 8 and one of the loads 804 of FIG. 8 when activated and are configured to interrupt the power circuit 820 when deactivated. The power switches 902 can be activated and deactivated with switch drivers 912, which can provide the drive signal for activating and deactivating the power switches 902. The switch drivers 912 can provide the high activation voltage, such as a high DC voltage, for activating the power switches 902.

Between the internal voltage 910 and the power switches 902, a current can be detected. The current through a high side switch will be a forward current within the power circuit 820.

The current from each of the power switches 902 can be detected by an individual current sensor 914. The individual current sensors 914 are positioned between each of the power switches 902 and the protection switch 904.

The output of the current sensors 914 can be input into a current to voltage converter 916. The current to voltage converter 916 can be an operational amplifier based component which can output a voltage linearly related to the input current.

The output of the current to voltage converter 916 can be input into a low current comparator 918. The low current comparator 918 compares the current to a low current threshold 920, such as the low reverse current detection threshold ITH_low of FIG. 4, and outputs a first current threshold signal based on the low current threshold 920 being exceeded by the current.

The output of the low current comparator 918 either indicates the first current threshold signal or a non-first current threshold signal. The non-first current threshold signal being a signal based on the low current threshold 920 not being exceeded by the current. The output of the low current comparator 918 is input into a debounce filter 922.

The debounce filter 922 can output a change in state from the non-first current threshold signal to the first current threshold signal if the low current threshold 920 is exceeded by the current for a predefined length of time. Illustratively, for example, it has been discovered that using the current settling time for the ringing current as the predefined length time for the debounce filter 922 affords an unexpected solution to ringing current through the power circuit 820 because the current is allowed to ring for a length of time long enough to correct itself without keeping the power circuit 820 active when there is a weak mis-wiring, similar to that depicted in FIG. 2 except the load 804 will be mis-wired to connect to the power supply positive terminal 824 or the switch module positive terminal 830 of FIG. 8 rather than a load output of the switch module 802.

This implementation of the debounce filter 922 therefore prevents the power circuit 820 from being interrupted during normal operation. The predefined length of time for the debounce filter 922 can vary based on the frequency of the ringing.

The output of the current to voltage converter 916 can also and additionally be input into a high current comparator 924. The high current comparator 924 compares the current to a high current threshold 926, such as the high reverse current detection threshold ITH_high of FIG. 4, and outputs a second current threshold signal based on the high current threshold 926 being exceeded by the current.

The output of the high current comparator 924 either indicates the second current threshold signal or anon-second current threshold signal. The non-second current threshold signal being a signal based on the high current threshold 926 not being exceeded by the current. The high current comparator 924 is not shown coupled to a debounce filter because the second current threshold signal output from the high current comparator 924, can be an indication of a strong current mis-wiring similar to that depicted in FIG. 3 but with the power supply negative terminal 826 of FIG. 8 connected to the switch module positive terminal 830 and the power supply positive terminal 824 coupled to an output of the switch module 802.

Because the second current threshold signal can indicate the strong current mis-wiring, it should be quickly, which makes a debounce filter an impractical solution in most cases. The output of the high current comparator 924 and the debounce filter 922 can be input into an OR logic gate 928, which can output a digital signal indicating either the second current threshold signal is present from the high current comparator 924, the first current threshold signal is present from the debounce filter 922, or both signals are present.

If the second current threshold signal is not present and the first current threshold signal is not present, then the OR logic gate 928 will indicate that neither the low current threshold 920 nor the high current threshold 926 were exceeded by the current.

The low current comparator 918 and the high current comparator 924 can be coupled to a control logic 930. The control logic 930 can be coupled to the high current comparator 924 through the OR logic gate 928 while the control logic 930 can be coupled to the low current comparator 918 through the OR logic gate 928 and the debounce filter 922.

The control logic 930 opens each of the power switches 902 and interrupts the power circuit 820 based on the second current threshold signal being output by the high current comparator 924 or the first current threshold signal being output by the debounce filter 922. More particularly, the control logic 930 can provide a signal to the switch drivers 912 which will open the power switches 902.

The control logic 930 can also provide a signal to the protection switch 904 in order to connect the internal voltage 910 and the power switches 902 to an external voltage 932. The protection switch 904 can be coupled to the power switches 902 and to the control logic 930.

The protection switch 904 exposes the power circuit 820 to an external connection based on the second current threshold signal being output by the high current comparator 924 or the first current threshold signal being output by the debounce filter 922. The external connection can be an external ground for low side switches and an external voltage, like the switching module ground terminal 828 of FIG. 8 for the power supply 822, for high side switches.

Referring now to FIG. 10, therein is shown a schematic diagram of the switch module 802 of FIG. 8 with P-type high side switches. The P-type high side switches are depicted as power switches 1002 and a protection switch 1004.

The power switches 1002 are shown as a first power switch 1006 and an nth power switch 1008. The first power switch 1006 can provide the first output 808 of the switch module 802.

When activated, the first power switch 1006 can connect the first output 808 to an internal voltage 1010. The internal voltage 1010 is internal to the switch module 802 and can be provided by connection to the power supply positive terminal 824 of FIG. 8.

Similarly, the nth power switch 1008 can provide the nth output 816 and can connect the nth output 816 to the internal voltage 1010 when activated. For descriptive clarity, power switches 1002 for other outputs of the switch module 802, such as the second output 812 of FIG. 8 is not shown but has the same structure and operation as those depicted.

The power switches 1002 are individually configured to complete the power circuit 820 of FIG. 8 between the power supply 822 and one of the loads 804 when activated and are configured to interrupt the power circuit 820 when deactivated. The power switches 1002 can be activated and deactivated with switch drivers 1012, which can provide the drive signal for activating and deactivating the power switches 1002. The switch drivers 1012 can provide the high activation voltage, such as a high DC voltage, for activating the power switches 1002.

Between the internal voltage 1010 and the power switches 1002, a current can be detected. The current through a high side switch will be a forward current within the power circuit 820.

The current from each of the power switches 1002 can be detected by an individual current sensor 1014. The individual current sensors 1014 are positioned between each of the power switches 1002 and the protection switch 1004.

The output of the current sensors 1014 can be input into a current to voltage converter 1016. The current to voltage converter 1016 can be an operational amplifier based component which can output a voltage linearly related to the input current.

The output of the current to voltage converter 1016 can be input into a low current comparator 1018. The low current comparator 1018 compares the current to a low current threshold 1020, such as the low reverse current detection threshold ITH_low of FIG. 4, and outputs a first current threshold signal based on the low current threshold 1020 being exceeded by the current.

The output of the low current comparator 1018 either indicates a first current threshold signal or a non-first current threshold signal. The non-first current threshold signal being a signal based on the low current threshold 1020 not being exceeded by the current. The output of the low current comparator 1018 is input into a debounce filter 1022.

The debounce filter 1022 can output a change in state from the non-first current threshold signal to the first current threshold signal if the low current threshold 1020 is exceeded by the current for a predefined length of time. Illustratively, for example, it has been discovered that using the current settling time for the ringing current as the predefined length time for the debounce filter 1022 affords an unexpected solution to ringing current through the power circuit 820 because the current is allowed to ring for a length of time long enough to correct itself without keeping the power circuit 820 active when there is a weak mis-wiring, similar to that depicted in FIG. 2 except the load 804 will be mis-wired to connect to the power supply positive terminal 824 or the switch module positive terminal 830 of FIG. 8 rather than a load output of the switch module 802.

This implementation of the debounce filter 1022 therefore prevents the power circuit 820 from being interrupted during normal operation. The predefined length of time for the debounce filter 1022 can vary based on the frequency of the ringing.

The output of the current to voltage converter 1016 can also and additionally be input into a high current comparator 1024. The high current comparator 1024 compares the current to a high current threshold 1026, such as the high reverse current detection threshold ITH_high of FIG. 4, and outputs a second current threshold signal based on the high current threshold 1026 being exceeded by the current.

The output of the high current comparator 1024 either indicates a second current threshold signal or a non-second current threshold signal. The non-second current threshold signal being a signal based on the high current threshold 1026 not being exceeded by the current. The high current comparator 1024 is not shown coupled to a debounce filter because the second current threshold signal output from the high current comparator 1024, can be an indication of a strong current mis-wiring similar to that depicted in FIG. 3 but with the power supply negative terminal 826 of FIG. 8 connected to the switch module positive terminal 830 and the power supply positive terminal 824 coupled to an output of the switch module 802.

Because the second current threshold signal can indicate the strong current mis-wiring, it should be quickly, which makes a debounce filter an impractical solution in most cases. The output of the high current comparator 1024 and the debounce filter 1022 can be input into an OR logic gate 1028, which can output a digital signal indicating either the second current threshold signal is present from the high current comparator 1024, the first current threshold signal is present from the debounce filter 1022, or both signals are present.

If the second current threshold signal is not present and the first current threshold signal is not present, then the OR logic gate 1028 will indicate that neither the low current threshold 1020 nor the high current threshold 1026 were exceeded by the current.

The low current comparator 1018 and the high current comparator 1024 can be coupled to a control logic 1030. The control logic 1030 can be coupled to the high current comparator 1024 through the OR logic gate 1028 while the control logic 1030 can be coupled to the low current comparator 1018 through the OR logic gate 1028 and the debounce filter 1022.

The control logic 1030 opens each of the power switches 1002 and interrupts the power circuit 820 based on the second current threshold signal being output by the high current comparator 1024 or the first current threshold signal being output by the debounce filter 1022. More particularly, the control logic 1030 can provide a signal to the switch drivers 1012 which will open the power switches 1002.

The control logic 1030 can also provide a signal to the protection switch 1004 in order to connect the internal voltage 1010 and the power switches 1002 to an external voltage 1032. The protection switch 1004 can be coupled to the power switches 1002 and to the control logic 1030.

The protection switch 1004 exposes the power circuit 820 to an external connection based on the second current threshold signal being output by the high current comparator 1024 or the first current threshold signal being output by the debounce filter 1022. The external connection can be an external ground for low side switches and an external voltage for high side switches.

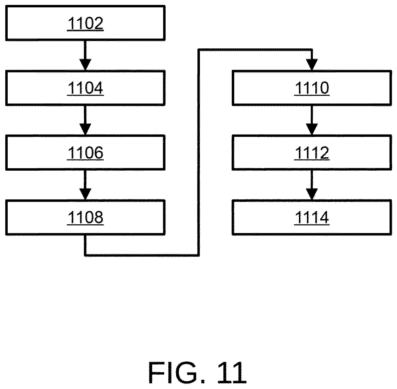

Referring now to FIG. 11, therein is shown a block diagram of a method of manufacturing the load switch system. The method of manufacturing can include configuring a power switch to complete or interrupt a power circuit between a power supply and a load in a block 1102; configuring a current sensor to detect current within the power circuit in a block 1104; coupling a low current comparator to the current sensor, the low current comparator compares the current to a low current threshold and outputs a first current threshold signal based on the low current threshold being exceeded by the current in a block 1106; coupling a debounce filter to the low current comparator, the debounce filter outputs the first current threshold signal based on the first current threshold signal remaining active for a predefined length of time in a block 1108; coupling a high current comparator to the current sensor, the high current comparator compares the current to a high current threshold and outputs a second current threshold signal based on the high current threshold being exceeded by the current in a block 1110; coupling a control logic to the low current comparator and to the high current comparator, the control logic opens the power switch and interrupts the power circuit based on the second current threshold signal being output by the high current comparator or the first current threshold signal being output by the debounce filter in a block 1112; and coupling a protection switch to the power switch and to the control logic, the protection switch exposes the power circuit to an external connection based on the second current threshold signal being output by the high current comparator or the first current threshold signal being output by the debounce filter in a block 1114.

Thus, it has been discovered that the load switch system furnishes important and heretofore unknown and unavailable solutions, capabilities, and functional aspects. The resulting configurations are straightforward, cost-effective, uncomplicated, highly versatile, accurate, sensitive, and effective, and can be implemented by adapting known components for ready, efficient, and economical manufacturing, application, and utilization.

The load switch system prevents intermittent false detections and loss of functionality when implemented with long wires and capacitive loads which is commonplace in industrial applications. The load switch system therefore provides reliable mis-wiring detection and protection for a load switch in industrial environments.

While the load switch system has been described in conjunction with a specific best mode, it is to be understood that many alternatives, modifications, and variations will be apparent to those skilled in the art in light of the preceding description. Accordingly, it is intended to embrace all such alternatives, modifications, and variations, which fall within the scope of the included claims. All matters set forth herein or shown in the accompanying drawings are to be interpreted in an illustrative and non-limiting sense.

### ASPECTS OF THE DISCLOSURE

Non-limiting aspects of the disclosure are set out in the following numbered clauses.
1. A load switch system comprising: a power switch configured to complete or interrupt a power circuit between a power supply and a load; a current sensor configured to detect current within the power circuit; a low current comparator coupled to the current sensor, the low current comparator compares the current to a low current threshold and outputs a first current threshold signal based on the low current threshold being exceeded by the current; a filter coupled to the low current comparator, the filter outputs the first current threshold signal based on the first current threshold signal remaining active for a predefined length of time; a high current comparator coupled to the current sensor, the high current comparator compares the current to a high current threshold and outputs a second current threshold signal based on the high current threshold being exceeded by the current; and a control logic coupled to the low current comparator and to the high current comparator, the control logic opens the power switch and interrupts the power circuit based on the second current threshold signal being output by the high current comparator or the first current threshold signal being output by the filter.
2. The system of clause 1 further comprising: a current to voltage converter coupled to the current sensor, the current to voltage converter converts the current from the current sensor to a voltage for comparison by the high current comparator and the low current comparator.
3. The system of any preceding clause further comprising: an OR logic gate coupled to a filter output of the filter and to a comparator output of the high current comparator.
4. The system of any preceding clause further comprising: a secondary power supply coupled to the power switch, the secondary power supply provides power to activate the power switch.
5. The system of any preceding clause further comprising: a switch driver coupled to the power switch, the switch driver provides a drive signal to the power switch.
6. A load switch system comprising: a power switch configured to complete or interrupt a power circuit between a power supply and a load; a current sensor configured to detect current within the power circuit; a low current comparator coupled to the current sensor, the low current comparator compares the current to a low current threshold and outputs a first current threshold signal based on the low current threshold being exceeded by the current; a filter coupled to the low current comparator, the filter outputs the first current threshold signal based on the first current threshold signal remaining active for a predefined length of time; a high current comparator coupled to the current sensor, the high current comparator compares the current to a high current threshold and outputs a second current threshold signal based on the high current threshold being exceeded by the current; a control logic coupled to the low current comparator and to the high current comparator, the control logic opens the power switch and interrupts the power circuit based on the second current threshold signal being output by the high current comparator or the first current threshold signal being output by the filter; and a protection switch coupled to the power switch and to the control logic, the protection switch exposes the power circuit to an external connection based on the second current threshold signal being output by the high current comparator or the first current threshold signal being output by the filter.
7. The system of clause 6 wherein: the load switch system is a low side load switch system; the power switch is coupled to an internal ground; and the protection switch exposes the power circuit to an external ground based on the second current threshold signal being output by the high current comparator or the first current threshold signal being output by the filter.
8. The system of clause 6 or clause 7 wherein: the load switch system is a high side load switch system; the power switch is coupled to an internal voltage; and the protection switch exposes the power circuit to an external voltage based on the second current threshold signal being output by the high current comparator or the first current threshold signal being output by the filter.
9. The system of any of clauses 6 to 8 wherein: the filter outputs the first current threshold signal based on the first current threshold signal remaining active for a settling time of the current.
10. The system of any of clauses 6 to 9 wherein: the power switch is a field effect transistor, a bipolar transistor, or a relay.
11. A method of manufacturing a load switch system comprising: configuring a power switch to complete or interrupt a power circuit between a power supply and a load; configuring a current sensor to detect current within the power circuit; coupling a low current comparator to the current sensor, the low current comparator compares the current to a low current threshold and outputs a first current threshold signal based on the low current threshold being exceeded by the current; coupling a filter to the low current comparator, the filter outputs the first current threshold signal based on the first current threshold signal remaining active for a predefined length of time; coupling a high current comparator to the current sensor, the high current comparator compares the current to a high current threshold and outputs a second current threshold signal based on the high current threshold being exceeded by the current; and coupling a control logic to the low current comparator and to the high current comparator, the control logic opens the power switch and interrupts the power circuit based on the second current threshold signal being output by the high current comparator or the first current threshold signal being output by the filter.
12. The method of clause 11 further comprising: coupling a current to voltage converter to the current sensor, the current to voltage converter converts the current from the current sensor to a voltage for comparison by the high current comparator and the low current comparator.
13. The method of clause 11 or clause 12 further comprising: coupling an OR logic gate to a filter output of the filter and to a comparator output of the high current comparator.
14. The method of any of clauses 11 to 13 further comprising: coupling a secondary power supply to the power switch, the secondary power supply provides power to activate the power switch.
15. The method of any of clauses 11 to 14 further comprising: coupling a switch driver to the power switch, the switch driver provides a drive signal to the power switch.
16. The method of any of clause 11 to 15 further comprising: coupling a protection switch to the power switch and to the control logic, the protection switch exposes the power circuit to an external connection based on the second current threshold signal being output by the high current comparator or the first current threshold signal being output by the filter.
17. The method of clause 16 wherein: manufacturing the load switch system includes manufacturing a low side load switch system; configuring the power switch includes coupling the power switch to an internal ground; and coupling the protection switch includes coupling the protection switch to an external ground, and the protection switch exposes the power circuit to the external ground based on the second current threshold signal being output by the high current comparator or the first current threshold signal being output by the filter.
18. The method of clause 16 or clause 17 wherein: manufacturing the load switch system includes manufacturing a high side load switch system; configuring the power switch includes coupling the power switch to an internal voltage; and coupling the protection switch includes coupling the protection switch to an external voltage, and the protection switch exposes the power circuit to the external voltage based on the second current threshold signal being output by the high current comparator or the first current threshold signal being output by the filter.
19. The method of any of clauses 16 to 18 wherein: coupling the filter includes configuring the filter to output the first current threshold signal based on the first current threshold remaining active for a settling time of the current.
20. The method of any of clauses 16 to 19 wherein: configuring the power switch includes configuring a field effect transistor, a bipolar transistor, or a relay.

## Claims

1. A load switch system comprising:
a power switch configured to complete or interrupt a power circuit between a power supply and a load;
a current sensor configured to detect current within the power circuit;
a low current comparator coupled to the current sensor, the low current comparator compares the current to a low current threshold and outputs a first current threshold signal based on the low current threshold being exceeded by the current;
a filter coupled to the low current comparator, the filter outputs the first current threshold signal based on the first current threshold signal remaining active for a predefined length of time;
a high current comparator coupled to the current sensor, the high current comparator compares the current to a high current threshold and outputs a second current threshold signal based on the high current threshold being exceeded by the current; and
a control logic coupled to the low current comparator and to the high current comparator, the control logic opens the power switch and interrupts the power circuit based on the second current threshold signal being output by the high current comparator or the first current threshold signal being output by the filter.

2. The system of claim 1 further comprising: a current to voltage converter coupled to the current sensor, the current to voltage converter converts the current from the current sensor to a voltage for comparison by the high current comparator and the low current comparator.

3. The system of any preceding claim further comprising: an OR logic gate coupled to a filter output of the filter and to a comparator output of the high current comparator.

4. The system of any preceding claim further comprising any one or more of:
(a) a secondary power supply coupled to the power switch, the secondary power supply provides power to activate the power switch;
(b) a switch driver coupled to the power switch, the switch driver provides a drive signal to the power switch.

5. The system of any preceding claim further comprising:
a protection switch coupled to the power switch and to the control logic, the protection switch exposes the power circuit to an external connection based on the second current threshold signal being output by the high current comparator or the first current threshold signal being output by the filter.

6. The system of claim 5 wherein:
the load switch system is a low side load switch system;
the power switch is coupled to an internal ground; and
the protection switch exposes the power circuit to an external ground based on the second current threshold signal being output by the high current comparator or the first current threshold signal being output by the filter.

7. The system of claim 5 or claim 6 wherein:
the load switch system is a high side load switch system;
the power switch is coupled to an internal voltage; and
the protection switch exposes the power circuit to an external voltage based on the second current threshold signal being output by the high current comparator or the first current threshold signal being output by the filter.

8. The system of any preceding claim wherein at least one of the following applies:
(a) the filter outputs the first current threshold signal based on the first current threshold signal remaining active for a settling time of the current;
(b) the power switch is a field effect transistor, a bipolar transistor, or a relay.

9. A method of manufacturing a load switch system comprising:
configuring a power switch to complete or interrupt a power circuit between a power supply and a load;
configuring a current sensor to detect current within the power circuit;
coupling a low current comparator to the current sensor, the low current comparator compares the current to a low current threshold and outputs a first current threshold signal based on the low current threshold being exceeded by the current;
coupling a filter to the low current comparator, the filter outputs the first current threshold signal based on the first current threshold signal remaining active for a predefined length of time;
coupling a high current comparator to the current sensor, the high current comparator compares the current to a high current threshold and outputs a second current threshold signal based on the high current threshold being exceeded by the current; and
coupling a control logic to the low current comparator and to the high current comparator, the control logic opens the power switch and interrupts the power circuit based on the second current threshold signal being output by the high current comparator or the first current threshold signal being output by the filter.

10. The method of claim 9 further comprising: coupling a current to voltage converter to the current sensor, the current to voltage converter converts the current from the current sensor to a voltage for comparison by the high current comparator and the low current comparator.

11. The method of claim 9 or claim 10 further comprising any one or more of:
(a) coupling an OR logic gate to a filter output of the filter and to a comparator output of the high current comparator;
(b) coupling a secondary power supply to the power switch, the secondary power supply provides power to activate the power switch;
(c) coupling a switch driver to the power switch, the switch driver provides a drive signal to the power switch.

12. The method of any of claim 9 to 11 further comprising: coupling a protection switch to the power switch and to the control logic, the protection switch exposes the power circuit to an external connection based on the second current threshold signal being output by the high current comparator or the first current threshold signal being output by the filter.

13. The method of claim 12 wherein:
manufacturing the load switch system includes manufacturing a low side load switch system;
configuring the power switch includes coupling the power switch to an internal ground; and
coupling the protection switch includes coupling the protection switch to an external ground, and the protection switch exposes the power circuit to the external ground based on the second current threshold signal being output by the high current comparator or the first current threshold signal being output by the filter.

14. The method of claim 12 or claim 13 wherein:
manufacturing the load switch system includes manufacturing a high side load switch system;
configuring the power switch includes coupling the power switch to an internal voltage; and
coupling the protection switch includes coupling the protection switch to an external voltage, and the protection switch exposes the power circuit to the external voltage based on the second current threshold signal being output by the high current comparator or the first current threshold signal being output by the filter.

15. The method of any of claims 12 to 14 wherein any one or more of the following applies:
(a) coupling the filter includes configuring the filter to output the first current threshold signal based on the first current threshold remaining active for a settling time of the current;
(b) configuring the power switch includes configuring a field effect transistor, a bipolar transistor, or a relay.
